# EUROPEAN PATENT SPECIFICATION

(11) **EP 0 644 277 B1**
(45) Date of publication and mention of the grant of the patent: **03.11.1999**
(21) Application number: 93910426.1
(22) Date of filing: 01.06.1993
(51) Int. Cl.: C30B 29/20, C01F 7/44, C01F 7/32

(54) **PROCESS FOR PRODUCING ALPHA-ALUMINA**
VERFAHREN ZUR HERSTELLUNG VON ALPHA-ALUMINIUMOXID
PROCEDE DE PRODUCTION D'ALPHA-ALUMINE

(30) Priority: 02.06.1992 JP 16838592; 28.10.1992 JP 31405292
(43) Date of publication of application: 22.03.1995
(73) Proprietor: Sumitomo Chemical Company, Limited, Chuo-ku Osaka 541-8550 (JP)
(72) Inventor: MOHRI, Masahide 277-4, Shimoyokoba, Ibaraki 305 (JP); UCHIDA, Yoshio Katsuragi Ryou 204, Tsukuba-shi Ibaraki 305 (JP); SAWABE, Yoshinari 550, Kitaohta, Ibaraki 300-42 (JP); WATANABE, Hisashi Katsuragi Ryou 410, Tsukuba-shi Ibaraki 305 (JP)
(74) Representative: Dixon, Donald Cossar
(86) International application number: PCT/JP93/00737
(87) International publication number: WO 93/24680

(56) References cited:
- EP-A- 0 105 025
- EP-A- 0 281 265
- WO-A-90/15777
- JP-A- 59 097 528
- JP-A- 60 131 825
- JP-A- 63 303 809
- US-A- 4 822 592
- CHEMICAL ABSTRACTS, vol. 105, no. 14, October 1986, Columbus, Ohio, US; abstract no. 117463, B. BOGDANOV ET AL. 'Effect of some additives on the specific surface of alumina obtained from aluminum-ammonium alum.' page 144 ;
- CHEMICAL ABSTRACTS, vol. 104, no. 10, March 1986, Columbus, Ohio, US; abstract no. 71187, Z. RYTIR ET AL. 'Alpha-alumina.' page 138 ;

## Description

### TECHNICAL FIELD

This invention relates to a process for producing α-alumina. α-Alumina powder has been widely used as an abrasive, a raw material for sintered products, a plasma spraying material, a filler and the like. The α-alumina produced by the process of the present invention comprises α-alumina single crystal particles which are not agglomerated particles and have a narrow particle size distribution, and is suitable as an abrasive, a raw material for sintered products, a plasma spraying material, a filler, a raw material for single crystals, a raw material for a carrier for catalysts, a raw material for fluorescent substances, a raw material for encapsulations, a raw material for ceramic filters, etc.

### BACKGROUND ART

α-Alumina powder obtained by conventional processes comprises irregular-shaped polycrystals, contains many agglomerated particles, and has a broad particle size distribution. For some uses, the purity of conventional α-alumina powder is insufficient. In order to overcome these problems, α-alumina powder produced by special processes as hereinafter described has been employed for specific uses. However, these special processes still fail to arbitrarily control the shape or particle diameter of α-alumina. It has thus been difficult to obtain α-alumina powder having a narrow particle size distribution.

Known special processes for producing α-alumina powder include a process utilizing a hydrothermal reaction of aluminum hydroxide (hereinafter referred to as hydrothermal treatment process); a process comprising adding a flux to aluminum oxide, fusing, and precipitating (hereinafter referred to as flux process); and a process in which aluminum hydroxide is calcined in the presence of a mineralizer.

With respect to a hydrothermal treatment process, JP-B-57-22886 (the term "JP-B" as used herein means an "examined published Japanese patent application") discloses a process in which corundum is added as a seed crystal to control the particle size. The process consists of synthesis in a high temperature under a high pressure, making the resulting α-alumina powder expensive.

According to the study by Matsui, et al. (Hydrothermal Hannou (Hydrothermal Reactions), Vol. 2, pp. 71-78 "Growth of Alumina Single Crystal by Hydrothermal Method"), an α-alumina single crystal obtained by hydrothermal growth of an alumina single crystal containing chromium on a sapphire (α-alumina) seed crystal contains cracks. On examining the homogeneity of the crystal in an attempt to clarify the cause of the cracks, it was confirmed that a high strain exists in the boundary between the seed crystal and the grown crystal and that the density of etch pit in the grown crystal near the boundary, which seems to correspond to a dislocation density, is high. The report goes that the cracks are expected to relate to such a strain or a defect and that a hydrothermal growth process is easily accompanied by incorporation of a hydroxyl group or water into crystals, which appears to cause a strain or a defect.

A flux process has been proposed as a means for controlling the shape or particle size of α-alumina powder for use as an abrasive, a filler, etc. For example, JP-A-3-131517 (the term "JP-A" as used herein means an "unexamined published Japanese patent application") discloses a process comprising calcining aluminum hydroxide in the presence of a flux with fluorine having a melting point of not more than 800°C to prepare α-alumina particles having an average particle diameter of from 2 to 20 µm and a hexagonal plate shape with a D/H ratio of from 5 to 40, wherein D represents a maximum particle diameter parallel to a hexagonal lattice plane of a hexagonal close-packed lattice of α-alumina, and H represents a diameter perpendicular to the hexagonal lattice plane. However, this process cannot provide fine α-alumina powder having a particle diameter of less than 2 µm, and all the particles obtained have a plate shape. It was impossible in the process to arbitrarily control the shape or size of α-alumina particles. Besides, the resulting α-alumina powder is not always suitable for use as an abrasive, a filler and a raw material for single crystals.

The Bayer process is a commonly employed and the least expensive process for producing α-alumina powder. In the Bayer process, bauxite is once converted to aluminum hydroxide or transition alumina, which is then calcined in air to prepare α-alumina powder.

The aluminum hydroxide or transition alumina which is obtained as an intermediate product on an industrial scale at low cost comprises large agglomerates having a particle diameter of greater than 10 µm. Conventional α-alumina powder obtained by calcination of such aluminum hydroxide or transition alumina in air comprises particles of irregular shape containing agglomerated coarse particles. The α-alumina powder containing agglomerated coarse particles are ground into final products by means of a ball mill, a vibration mill, etc., but grinding is not always easy and incurs the cost. α-Alumina powder having difficulty in grinding needs an extended period of time for grinding, during which fine powder may be formed or foreign materials may be incorporated only to provide α-alumina powder unsuitable as an abrasive.

Several proposals have been made to date as a solution to these problems. For example, JP-A-59-97528 discloses a process for improving the shape of α-alumina powder comprising calcining aluminum hydroxide prepared by the Bayer process in the presence of boron containing ammonium and a boron mineralizer to obtain α-alumina powder having an average particle diameter of from 1 to 10 µm and a D/H ratio approximate to 1. However, this process involves problems in that the boron-containing or fluorine-containing material added as a mineralizer remains in the resulting α-alumina and agglomerates are formed upon calcining.

In connection to calcination of sodium-containing aluminum hydroxide prepared by the Bayer process, it has been proposed to conduct calcining in the presence of a fluoride, e.g., aluminum fluoride or cryolite, and a chlorine-containing material, e.g., chlorine or hydrogen chloride in GB-A-990,801 or in the presence of boric acid, and ammonium chloride, hydrochloric acid or aluminum chloride in DE-A-1,767,511 for the purpose of effectively removing sodium while controlling the particle diameter.

However, in the former process, since a mineralizer such as aluminum fluoride is added in a solid form or the calcination is conducted while supplying chlorine gas and fluorine gas without the addition of water, the resulting alumina particles have problems of an irregular shape and a broad particle size distribution. The latter process also involves a problem in that boric acid as a mineralizer remains in the resulting α-alumina in the form of a boron-containing material. In addition, these processes aim chiefly at removal of sodium, and the sodium salt, such as NaCℓ or Na₂SO₄, by-produced by the reaction between sodium and a sodium removing agent must be sublimed or decomposed by calcination at a high temperature of at least 1200°C.

With respect to the reaction between alumina and hydrogen chloride gas, there is a report in Zeit. fur Anorg. und Allg, Chem., Vol 21, p. 209 (1932) of an equilibrium constant of the reaction system comprising sintered α-alumina having a particle diameter of from 2 to 3 mm, hydrogen chloride, and produced aluminum chloride. According to the report, while α-alumina is found produced in a place different from the place where the starting material has been charged, only hexagonal plate-shaped particles are obtained.

JP-B-43-8929 discloses a process comprising calcining alumina hydrate in the presence of ammonium chloride to produce alumina having a low impurity content and an average particle diameter of not more than 10 µm. The resulting alumina powder has a broad particle size distribution.

EP-A-105025 discloses the preparation of α-alumina by calcination of aluminum hydroxide in the presence of ammonium-containing mineralizers like NH₄Cℓ at 1,100°C. However, the presence of a boron compound is essential, and EP-A-105025 does not disclose a concentration of hydrogen chloride or of chlorine + steam in the calcination atmosphere. Further, the powder formed is a powder containing many agglomerated particles.

EP-A-281 265 discloses a process of calcining transition alumina by adding a chlorine-containing substance in an amount or 0.1-10 wt%. However, EP-A-281 265 does not disclose a concentration of hydrogen chloride or of chlorine + steam in the calcination atmosphere. Further, the alumina powder formed contains many agglomerated particles which requires pulverization with a ball-mill.

WO-A-9015777 discloses a process of calcining aluminum hydrate particles precipitated from an aqueous solution containing α-alumina promoter, in the presence of a chlorine or fluoride, chloride, or boron-containing mineralizer. However, WO-A-9015777 does not disclose a concentration of hydrogen chloride or of chlorine + steam in the calcination atmosphere. Further, the powder formed is a powder containing many agglomerated particles.

Therefore, none of the conventional techniques succeeded in providing α-alumina comprising α-alumina single crystal particles and satisfying requirements of purity and structural homogeneity of individual particles.

An object of the present invention is to solve the above problems and to provide a process for producing α-alumina in a powder form which comprises homogeneous and non-agglomerated α-alumina single crystal particles from various raw materials. More specifically, it is to provide a process for producing α-alumina in a powder form comprising α-alumina single crystal particles which have an octa- or higher polyhedral shape, a D/H ratio of from 0.5 to 3.0, a narrow particle size distribution, and a high alumina purity, with the individual particles being uniform in composition and freed of structural strain.

The present invention relates to the following inventions:
(1) a process for producing α-alumina in a powder form comprising homogeneous and non-agglomerated α-alumina single crystal particles which have an octa- or higher polyhedral shape and a D/H ratio of from 0.5 to 3.0, wherein D represents a maximum particle diameter parallel to a hexagonal lattice plane of a hexagonal close-packed lattice of said particles, and H represents a diameter perpendicular to a hexagonal lattice plane, characterized in that transition alumina and/or a transition alumina precursor which is capable of being converted to transition alumina on heating is calcined in an atmosphere containing at least 10% by volume of hydrogen chloride at a temperature of not less than 600°C and the calcining time is 10 minutes or more up to 120 minutes.
(2) A process for producing α-alumina in powder form comprising homogeneous and non-agglomerated α-alumina single crystal particles which have an octa- or higher polyhedral shape and a D/H ratio of from 0.5 to 3.0, wherein D represents a maximum particle diameter parallel to a hexagonal lattice plane of a hexagonal close-packed lattice of said particles, and H represents a diameter perpendicular to a hexagonal lattice plane, characterized in that transition alumina and/or a transition alumina precursor which is capable of being converted to transition alumina on heating is calcined, while at least 1% by volume of chlorine and at least 0.1% by volume of steam are introduced to an atmosphere, at a temperature of not less than 600°C.
(3) A process for producing α-alumina as described in (1) or (2) above, wherein the calcining temperature is from 600 to 1,400°C
(4) A process for producing α-alumina as described in (1) or (2) above, wherein the calcining temperature is from 800 to 1,200°C.
(5) A process for producing α-alumina as described in (1), (2) or (3) above, characterized in that said transition alumina precursor capable of being converted to transition alumina on heating is aluminum hydroxide.
(6) A process for producing α-alumina as described in (1), (2) or (3) above, characterized in that said transition alumina precursor capable of being converted to transition alumina on heating is alum or aluminum sulfate.
(7) A process for producing α-alumina according to (2) above, wherein at least 10% by volume of chlorine and at least 5% by volume of steam are introduced to an atmosphere.

### BRIEF DESCRIPTION OF THE DRAWINGS

Fig. 1 is a scanning electron microscope (SEM) photograph (magnification: 930) showing the particulate shape of the α-alumina obtained in Example 1.

Fig. 2 is a scanning electron microscope (SEM) photograph (magnification: 930) showing the particulate shape of the α-alumina obtained in Example 2.

Fig. 3 is a particle size distribution of the α-alumina obtained in Example 2.

Fig. 4 is an SEM photograph (magnification: 1,900) showing the particulate shape of the α-alumina obtained in Comparative Example 8.

Fig. 5 is an SEM photograph (magnification: 930) showing the particulate shape of the α-alumina obtained in Example 17.

Fig. 6 is an SEM photograph (magnification: 930) showing the particulate shape of the α-alumina obtained in Comparative Example 1.

Fig. 7 is an SEM photograph (magnification: 1,900) showing the particulate shape of the α-alumina obtained in Comparative Example 5.

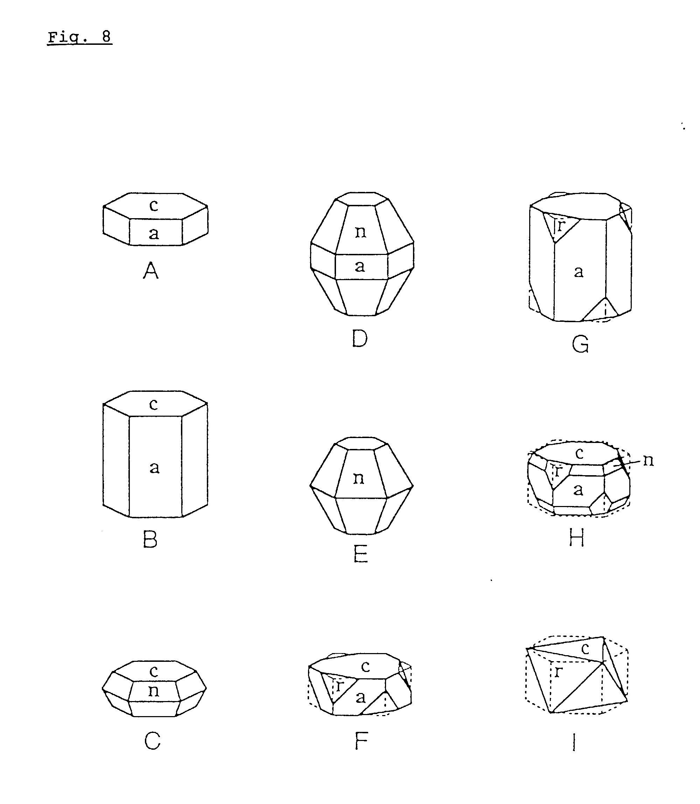

Fig. 8 shows the crystal habit of an α-alumina single crystal.

### BEST MODE FOR PRACTICING THE INVENTION

The present invention is described in detail below.

In the process for producing α-alumina according to the present invention, transition alumina or an alumina raw material converted to transition alumina on heating are used. Transition alumina means all alumina crystal phases included under polymorphic alumina represented by Aℓ₂O₃ except α-alumina, specifically including γ-alumina, δ-alumina, θ-alumina, etc.

The term a raw material capable of being converted to transition alumina on heating include those which are once converted to transition alumina and then to α-alumina by calcination according to the present invention, such as aluminum hydroxide, aluminum sulfate, alum (e.g., potassium aluminum sulfate, ammonium aluminum sulfate), ammonium aluminum carbonate hydroxide, and alumina gel (e.g., alumina gel obtained by oxidation of aluminum by electro-discharging in water).

Synthesis methods of the transition alumina and the alumina raw material converted to transition alumina on heating are not particularly limited. Aluminum hydroxide, for example, can be obtained by the Bayer process, hydrolysis of an organoaluminum compound, or a process using, as a starting material, an aluminum compound recovered from an etching waste used for condensers, etc.

According to the process of the present invention, α-alumina in a powder form with desired characteristics can be produced from aluminum hydroxide or transition alumina whose secondary particle diameter is 10 µm or greater which is obtained by an industrial and economical process, such as the Bayer process.

Transition alumina can be obtained by a heat treatment of aluminum hydroxide, decomposition of aluminum sulfate, decomposition of alum, vapor phase decomposition of aluminum chloride, or decomposition of ammonium aluminum carbonate.

In carrying out the present invention as one embodiment, the transition alumina or the alumina raw material converted to transition alumina on heating is calcined in an atmosphere containing at least 10% by volume, of hydrogen chloride gas. Gases for dilution of hydrogen chloride gas include inert gases, e.g., nitrogen and argon, hydrogen and air. The pressure of the hydrogen chloride-containing atmosphere is not particularly limited and is selected arbitrarily from an industrially practical range. α-Alumina in a powder form having the excellent properties as desired can thus be obtained by calcination in a relatively low temperature as hereinafter described.

Hydrogen chloride gas may be replaced with a mixed gas of chlorine and steam. In this case, transition alumina or an alumina raw material converted to transition alumina on heating is calcined, while at least 1% by volume, preferably at least 5% by volume, and more preferably at least 10% by volume, of chlorine gas and at least 0.1% by volume, preferably at least 1% by volume, and more preferably at least 5% by volume, of steam, are introduced to an atmosphere. Gases for diluting the mixed gas of chlorine and steam include inert gases, e.g., nitrogen and argon, hydrogen and air. The pressure of the chlorine- and steam-containing atmosphere is not particularly limited and is selected arbitrarily from an industrially practical range. α-Alumina in a powder form having the excellent properties as desired can thus be obtained by calcination in a relatively low temperature as hereinafter described.

The calcining temperature is 600°C or higher, preferably from 600 to 1,400°C, more preferably from 700 to 1,300°C, and most preferably from 800 to 1,200°C. By calcining at a temperature controlled within this range, α-alumina in a powder form comprising α-alumina single crystal particles which are hardly agglomerated and, even immediately after calcination, have a narrow particle size distribution can be obtained at an industrially advantageous rate of formation. Where the raw material comprises large particles of transition alumina or a precursor thereof, for example, agglomerated particles having an average particle diameter exceeding 10 µm, the calcining temperature is preferably set relatively high, especially at 800°C or higher.

A proper calcining time depends on the concentration of the gas in the calcining atmosphere and the calcining temperature but is preferably 1 minute or more, and more preferably 10 minutes or more and at least 10 minutes or more up to 120 minutes in case the transition alumina and/or the transition alumina precursor is calcined in an atmosphere containing at least 10% by volume of hydrogen chloride. The calcining time is sufficient if the alumina raw material undergoes crystal growth to form α-alumina. The process of the present invention makes it possible to obtain α-alumina in a shorter calcining time than required in the conventional processes.

The source and the mode of supplying of the gas of the calcining atmosphere are not particularly restricted as long as the chlorine-containing gas is introduced into the reaction system containing the starting material. For example, the component gases may be supplied from gas cylinders. Where a chlorine compound, e.g., hydrochloric acid solution, ammonium chloride, or a chlorine-containing' high polymer is used as a source for the hydrogen chloride gas, it is used at its vapor pressure or as decomposed so as to give a prescribed gas composition. In some cases of using decomposition gas of ammonium chloride, etc., a solid substance deposits in a calcining furnace to cause operational troubles. -Further, as the hydrogen chloride gas concentration increases, the calcination can be effected at a lower temperature in a shorter time, and the purity of the resulting α-alumina can be increased. Accordingly, it is preferable to supply hydrogen chloride or chlorine directly from a gas cylinder into a calcining furnace. The gas supply may be either in a continuous manner or in a batch system.

The calcining apparatus which can be used in the present invention is not particularly limited, and a conventional calcining furnace can be employed. The calcining furnace is preferably made of a material resistant to corrosion by hydrogen chloride gas, chlorine gas, etc. The furnace is preferably equipped with a mechanism for controlling the atmosphere. Because an acid gas, e.g., hydrogen chloride or chlorine gas, is used, the furnace is preferably air-tight. For industrial production, calcination is preferably carried out in a continuous manner by means of, for example, a tunnel kiln, a rotary kiln, a pusher kiln, etc.

Since the reaction proceeds in an acidic atmosphere, a crucible, a boat or a like tool used in the process is preferably made of alumina, quartz, acid resistant brick, or graphite.

According to the process of the present invention, α-alumina which is not agglomerated particles can be obtained. Depending on the starting material or the conditions of calcination, the resulting α-alumina may be agglomerated particles or may contain agglomerated particles. Even in such cases, the degree of agglomeration is very slight, and simple grinding will provide α-alumina which is not agglomerated.

α-Alumina single crystal particles constituting α-alumina obtained by the process of the present invention have such excellent properties that the number average particle diameter is from 0.1 to 30 µm, the D/H ratio is from 0.5 to 3.0, the particle size distribution is narrow in that the D90/D10 ratio is not more than 10, preferably not more than 9, more preferably not more than 7, wherein D10 and D90 represent a cumulative 10% diameter and a cumulative 90% diameter, respectively of a cumulative distribution depicted from the smaller diameter side, and the purity is high in that the alumina purity is 99.90% by weight or higher and the sodium content is less than 0.05% by weight in terms of Na₂O.

The present invention will now be illustrated in greater detail with reference to Examples, but it should be understood that the present invention is not construed as being limited thereto.

Various measurements in Examples and Comparative Examples were made as follows.

### 1. Particle Diameter and Particle Diameter Distribution of α-Alumina:

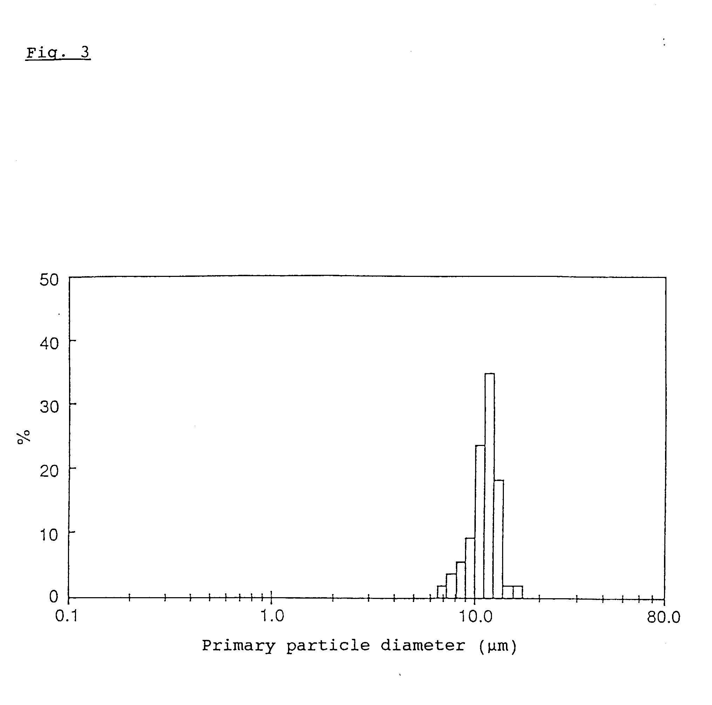

(1) A D90/D10 ratio was measured by laser scattering method with "Master Sizer" manufactured by Malvern Instruments, Ltd.
(2) A micrograph of α-alumina powder was taken with an SEM ("T-300" manufactured by Japan Electron Optics Laboratory Co., Ltd.), and selected 80 to 100 particles of the SEM photograph were subjected to image analysis to obtain an average and a distribution of their circle-equivalent diameters. The term "circle-equivalent diameter" as used herein means a diameter of a true circle having the same area as a particle. The resulting particle diameter distribution is shown in Fig. 3.

### 2. Crystal Shape (D/H) of α-Alumina:

The shape of α-alumina particles was represented in terms of a D/H ratio, wherein D and H are as defined above. A D/H ratio of α-alumina was obtained as an average of 5 to 10 particles by image analysis of the above-mentioned SEM photograph.

### 3. Number of Crystal Faces and Crystal Habit:

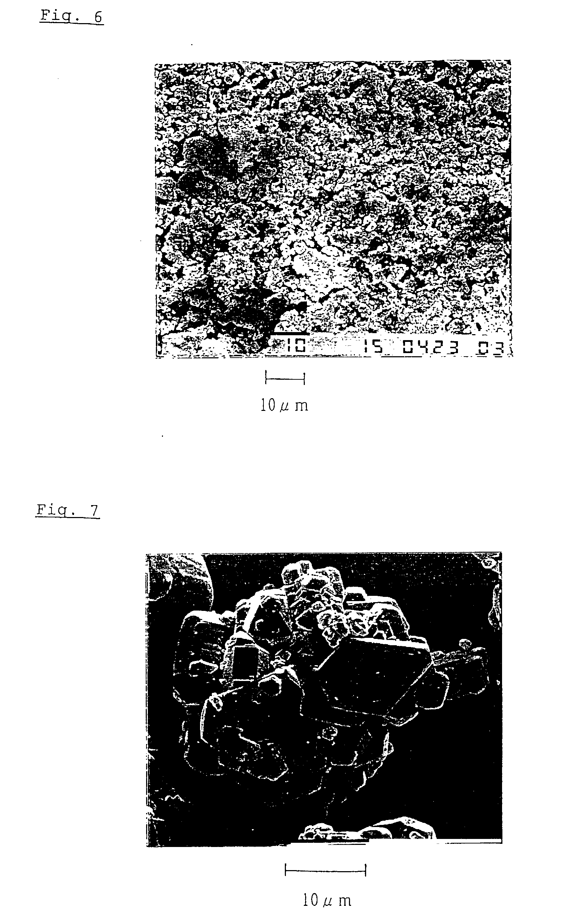

(1) The number of crystal faces of α-alumina was obtained by observation of the above-mentioned SEM ("T-300" manufactured by Japan Electron Optics Laboratory Co., Ltd.) photograph.
(2) The crystal habit of α-alumina particles was observed for evaluating the shape. The crystal habit of the α-alumina particles obtained in the present invention (indicated by A to I) is shown in Fig. 6. α-Alumina has a hexagonal system, and the term "crystal habit" used for α-alumina means the form of its crystal characterized by the appearance of the crystal faces composed of a plane {1120}, c plane {0001}, n plane {2243}, and r plane {1012}. In Fig. 6 are shown crystal planes a, c, n, and r.

### 4. Alumina Purity:

The amount of ions of incorporated impurities was measured by emission spectrochemical analysis to obtain the content of the impurities on oxide conversion. The chlorine content was measured by potentiometry. An alumina purity was obtained by subtracting the total impurity content (wt%) thus calculated from 100% by weight.

### 5. Na₂O Content:

The amount of a sodium ion incorporated was measured by emission spectrochemical analysis to obtain the content of Na₂O.

The raw materials used in Examples were as follows:

### 1. Transition Alumina A:

Transition alumina obtained by calcination of aluminum hydroxide prepared by hydrolysis of aluminum isopropoxide ("AKP-G15" produced by Sumitomo Chemical Co., Ltd.; secondary particle diameter: about 4 µm)

### 2. Transition Alumina B:

Transition alumina prepared by an alum method ("CR 125" produced by Baikouski Co., Ltd.; particle size: about 4 µm)

### 3. Transition Alumina C:

Transition alumina obtained by calcining aluminum hydroxide C hereinafter described in air at 800°C (secondary particle diameter: about 30 µm)

### 4. Aluminum Hydroxide A:

Aluminum hydroxide powder synthesized by hydrolysis of aluminum isopropoxide (secondary particle diameter: about 8 µm)

### 5. Aluminum Hydroxide B:

Aluminum hydroxide powder prepared by the Bayer process ("C 301" produced by Sumitomo Chemical Co., Ltd.; secondary particle diameter: about 2 µm)

### 6. Aluminum Hydroxide C:

Aluminum hydroxide powder prepared by the Bayer process ("C 12" produced by Sumitomo Chemical Co., Ltd.; secondary particle diameter: about 47 µm)

### 7. Alum (AℓNH₄(SO₄)₂·12H₂O):

An alumina precursor capable of being converted to transition alumina by a heat treatment. A reagent produced by Wako Pure Chemical Industries, Ltd. was used.

### 8. Aluminum Sulfate (Al₂(SO₄)₃·16H₂O):

An alumina precursor capable of being converted to transition alumina by a heat treatment. A product produced by Sumitomo Chemical Co., Ltd. was used.

Hydrogen chloride in a cylinder produced by Tsurumi Soda K.K. (purity: 99.9%) and a decomposition gas of ammonium chloride were used as a hydrogen chloride gas source. In using a decomposition gas of ammonium chloride, ammonium chloride was heated at its sublimation temperature, 300°C, and the resulting hydrogen chloride gas was introduced into the reaction system to adjust the atmosphere. Ammonium chloride was completely decomposed at a calcining temperature of 1,100°C to provide an atmosphere comprising 33% by volume of hydrogen chloride gas, 17% by volume of nitrogen gas, and 50% by volume of hydrogen gas.

Chlorine in a cylinder produced by Fujimoto Sangyo K.K. (purity: 99.4%) was used as a chlorine gas source. The volume percent of steam was controlled by adjusting the saturated vapor pressure of water dependent on temperature and introduced into a furnace with nitrogen gas.

An alumina boat was filled with 0.4 g of a raw material, such as transition alumina or aluminum hydroxide, to a depth of 5 mm. Calcination of the raw material was conducted in a tube furnace ("DSPSH-28" manufactured by Motoyama K.K.) using a quartz tube (diameter: 27 mm; length: 1000 mm). The temperature was increased at a rate of 500°C/hour while introducing nitrogen, and hydrogen chloride gas or a mixed gas of chlorine and steam was introduced into the furnace when a prescribed temperature was reached.

The gas concentration was controlled by adjustment of the gas flow rate by means of a flowmeter. The linear flow rate of the gas was set at 20 mm/min. This system was hereinafter referred to as a gas flow system. In Example 5 and Comparative Example 1 using a low hydrogen chloride gas concentration, calcination was carried out by a system in which introduction of the gas was ceased after a prescribed concentration was reached. The total pressure of the atmospheric gases was atmospheric pressure.

On reaching a prescribed temperature, the furnace was maintained at that temperature (hereinafter referred to as a calcining temperature) for a prescribed time (hereinafter referred to as a keeping time). After a lapse of a prescribed keeping time, the furnace was allowed to cool to obtain α-alumina in a powder form.

The steam partial pressure was controlled by adjusting the saturated vapor pressure, and steam was fed to the furnace with nitrogen gas.

### EXAMPLES 1 TO 3

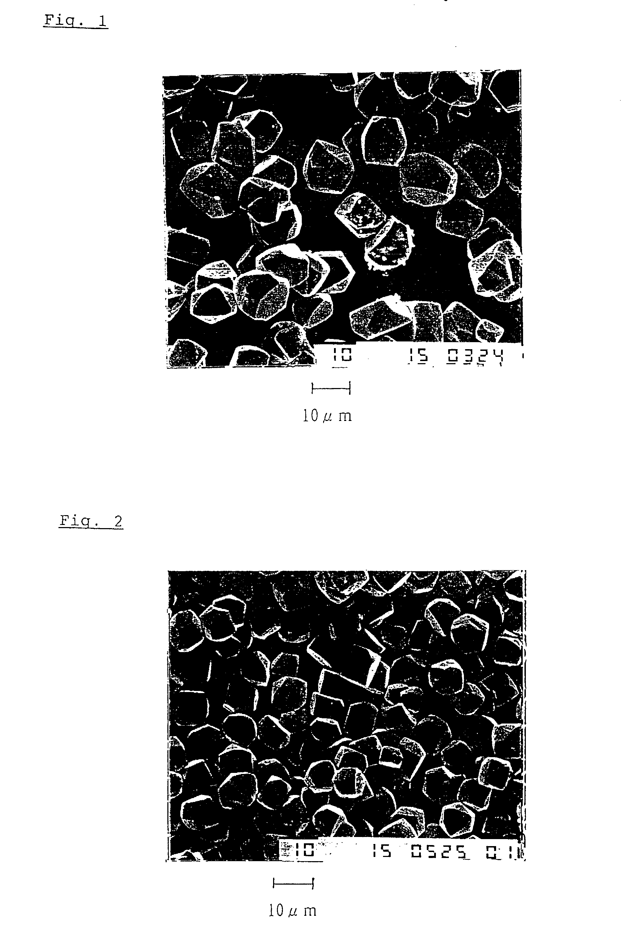

Transition alumina (γ-alumina) was calcined in an atmosphere having a varied hydrogen chloride gas concentration. The gas was introduced at 20°C, and the calcination was conducted at 1,100°C for a keeping time varied according to the hydrogen chloride gas concentration. The calcination conditions and the results are shown in Tables 1 and 2 below. The SEM photographs of the α-alumina obtained in Examples 1 and 2 are shown in Figs. 1 and 2, respectively. The particle diameter distribution of the α-alumina of Example 2 is shown in Fig. 3.

### EXAMPLE 4

Calcination of transition alumina was carried out in the same manner as in Example 1, except for changing the calcining temperature and the keeping time as shown in Table 1. The results obtained are shown in Table 2.

### EXAMPLES 5 AND 6

Calcination of transition alumina was carried out in the same manner as in Example 1, except for changing the temperature at which the gas was introduced and the keeping time as shown in Table 1. The results obtained are shown in Table 2.

### EXAMPLES 7 TO 13

Calcination of various raw materials was carried out under the conditions shown in Table 1. In Examples 7 to 10 a decomposition gas of ammonium chloride was used as a hydrogen chloride gas source. The results obtained are shown in Table 2.

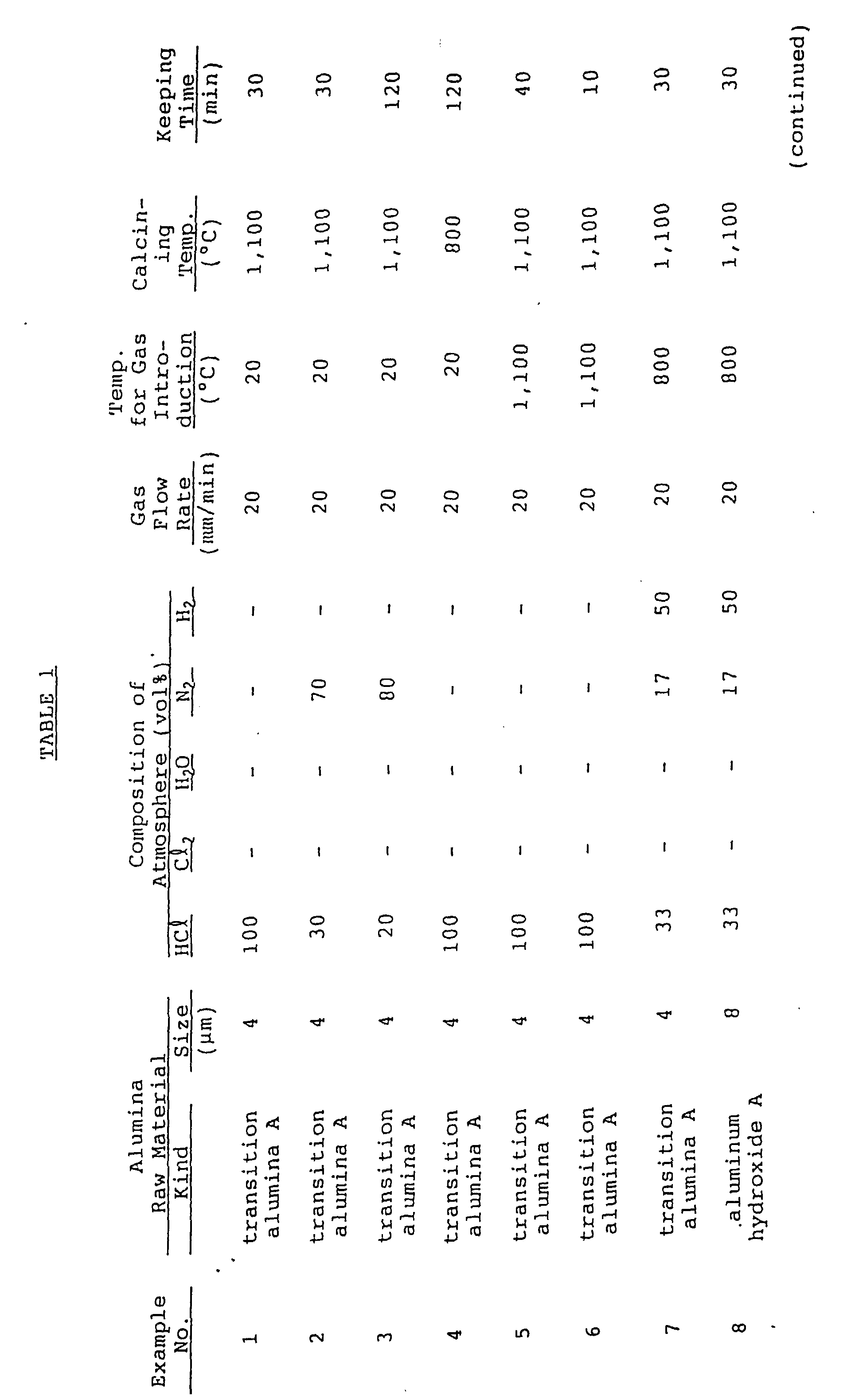

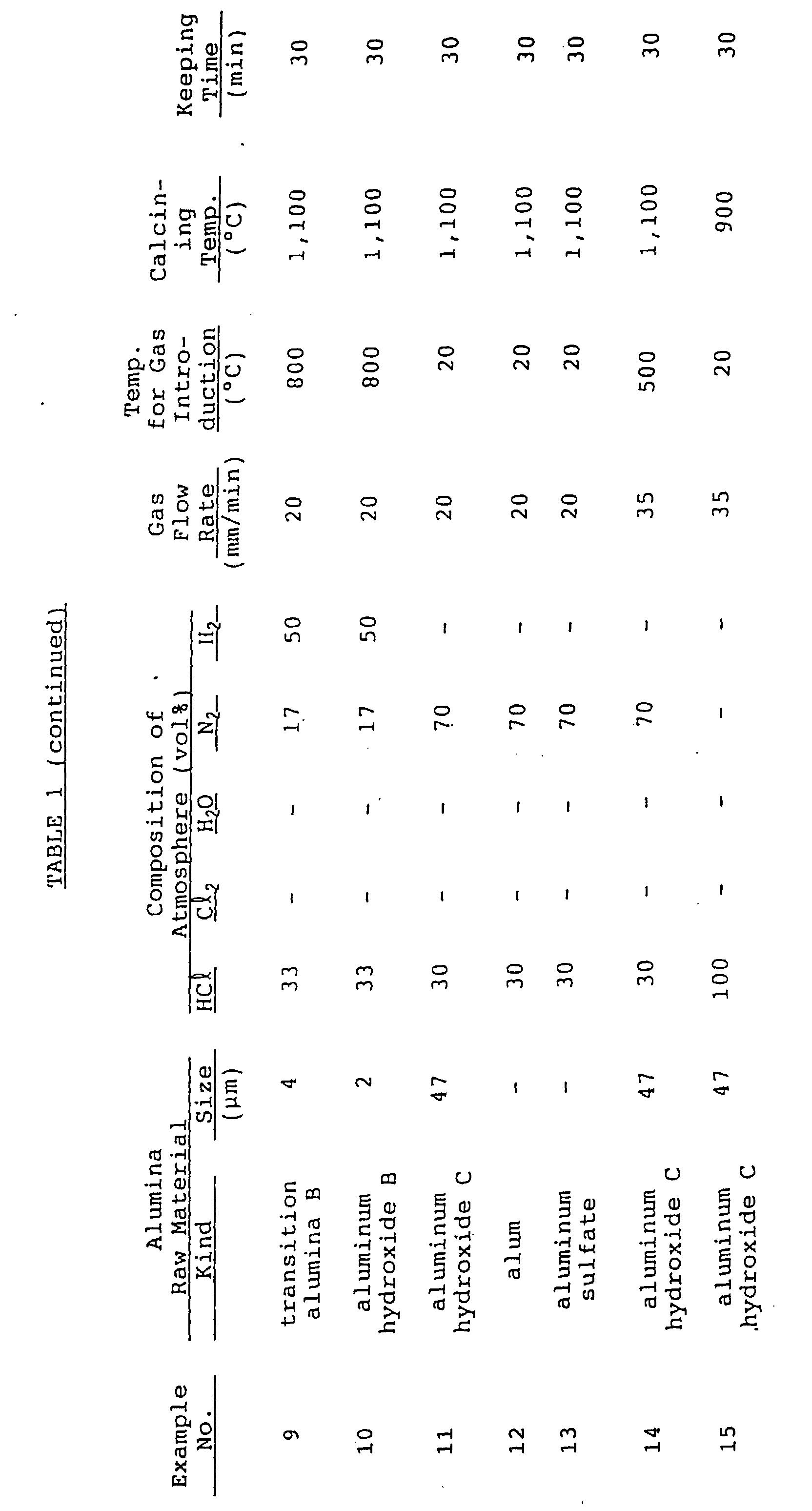

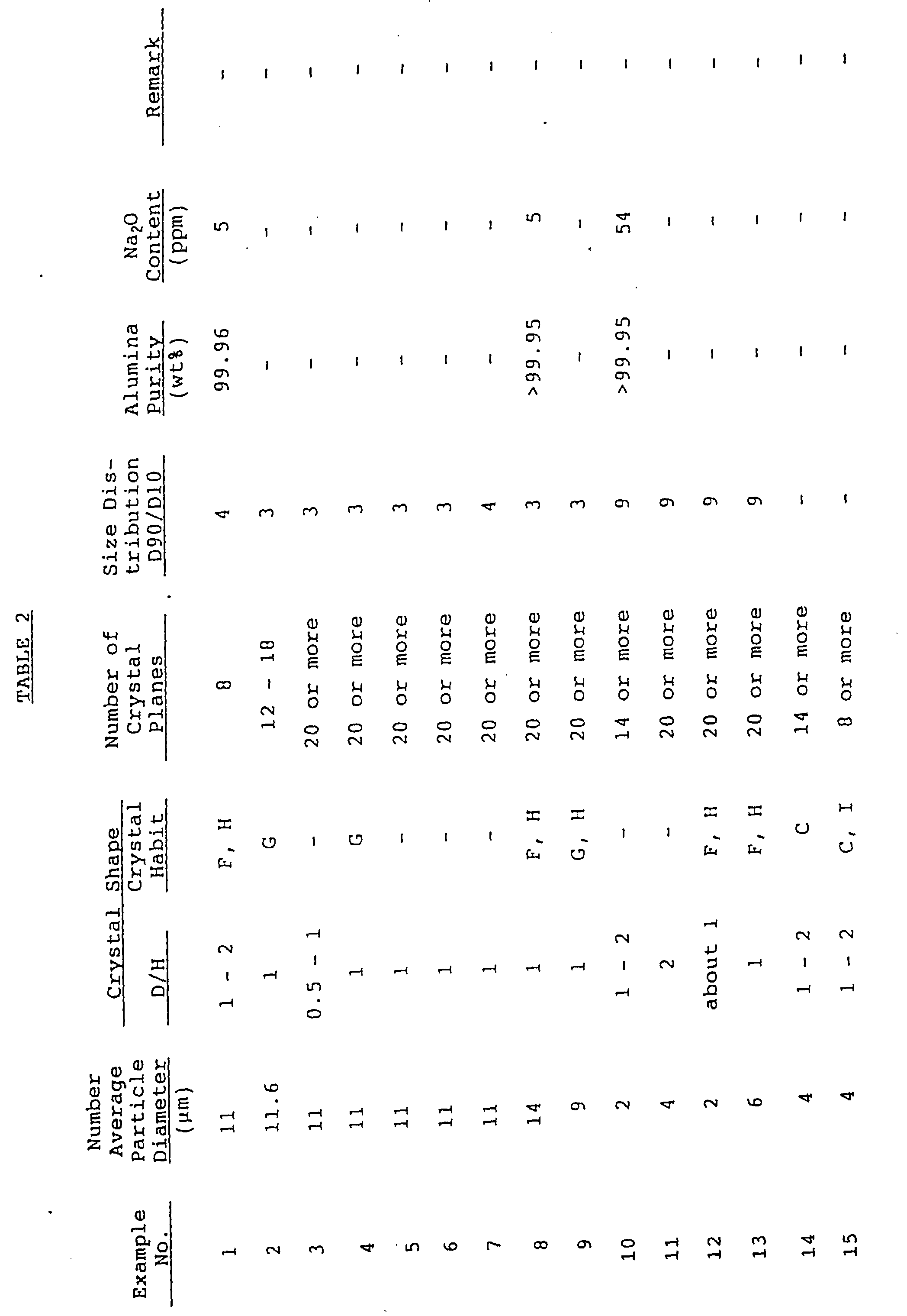

### EXAMPLES 14 AND 15

Aluminum hydroxide having a large particle size obtained by the Bayer process (aluminum hydroxide C) was calcined under the conditions shown in Table 1. The results obtained are shown in Table 2.

### EXAMPLE 16

Transition alumina C obtained by calcination of aluminum hydroxide powder having a large particle size obtained by the Bayer process (aluminum hydroxide C) was calcined under the conditions shown in Table 3. The results obtained are shown in Table 4.

### EXAMPLES 17 AND 18

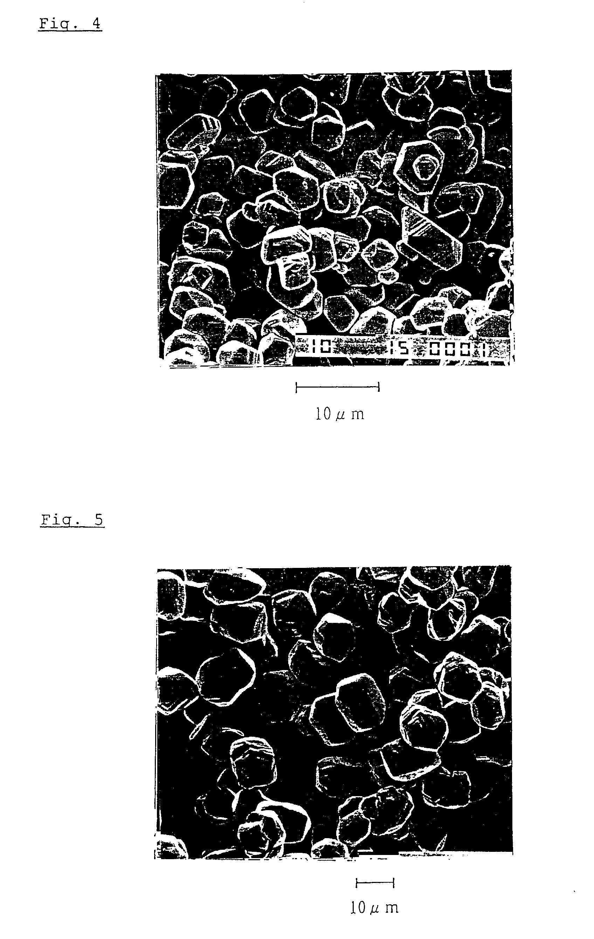

Transition alumina or aluminum hydroxide was calcined in an atmosphere containing chlorine gas and steam under the conditions shown in Table 3. The results obtained are shown in Table 4. The SEM photograph of the α-alumina obtained in Example 17 is shown in Fig. 5.

### COMPARATIVE EXAMPLES 1 TO 5

Calcination of transition alumina or aluminum hydroxide was carried out under conditions shown in Table 3 which were outside the scope of the present invention. The results obtained are shown in Table 4, and the SEM photographs of the α-alumina obtained in Comparative Examples 1 and 5 are shown in Figs. 6 and 7, respectively.

### COMPARATIVE EXAMPLES 6 AND 7

Calcination of transition alumina was carried out in the same manner as in Example 1. The calcination conditions and the results are shown in Tables 3 and 4.

### COMPARATIVE EXAMPLE 8

Aluminium hydroxide having a large particle size obtained by the Bayer process (aluminium hydroxide C) was calcined under the conditions shown in Table 3. The results obtained are shown in Table 4. The SEM photograph of the α-alumina obtained in Comparative Example 8 is shown in Fig. 4.

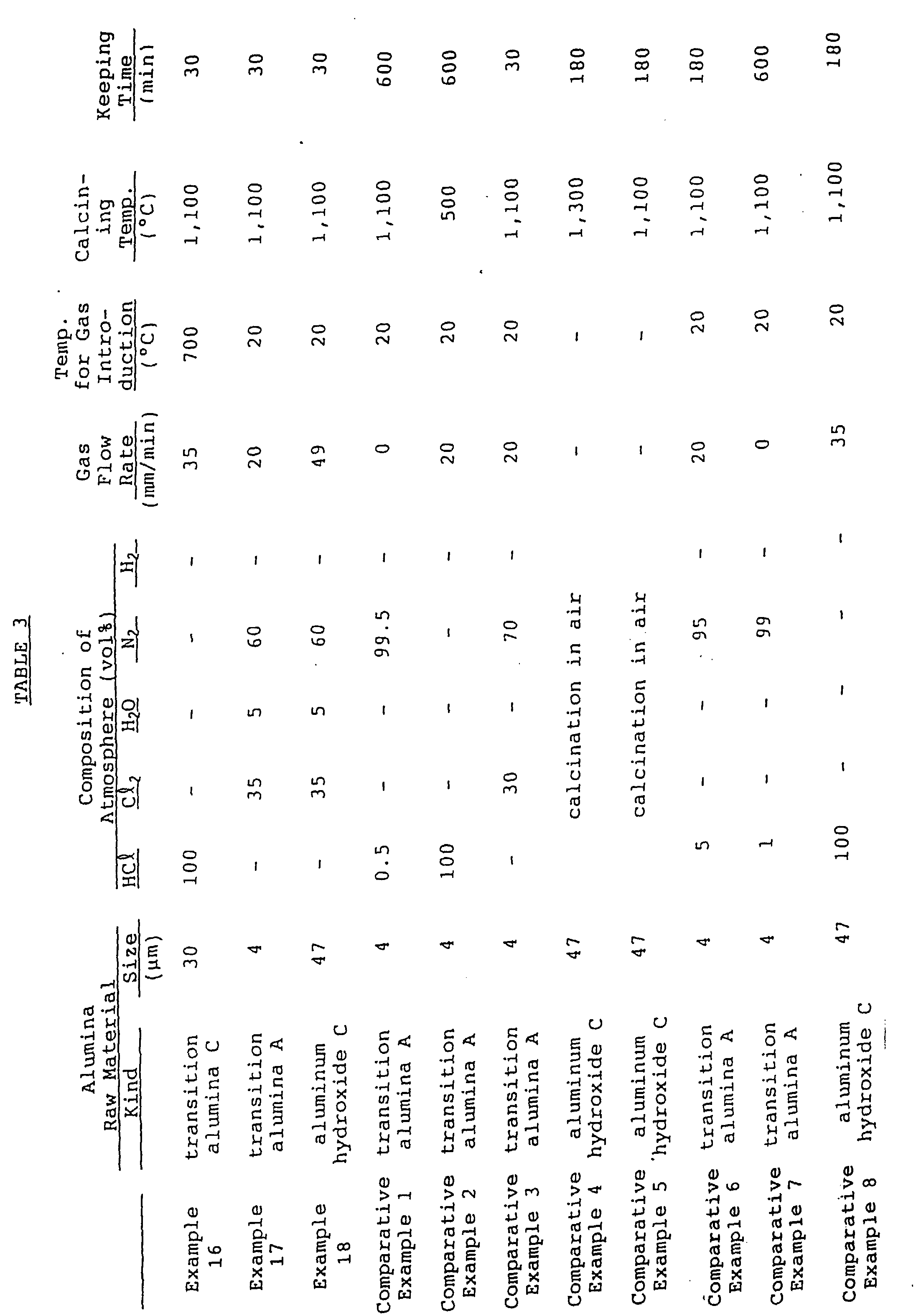

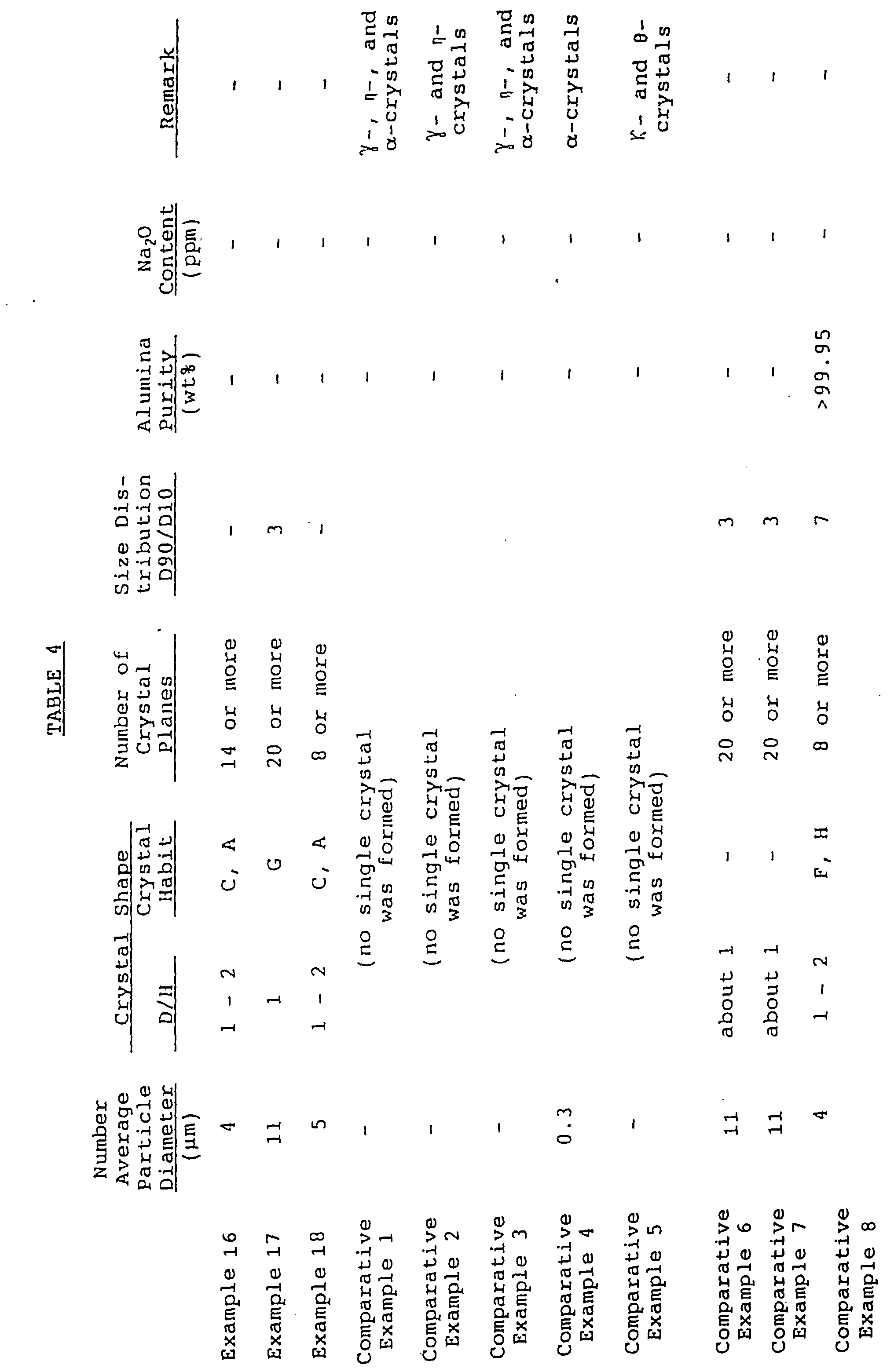

### INDUSTRIAL UTILITY

According to the process for producing α-alumina of the present invention, α-alumina comprising octahedral or higher polyhedral α-alumina single crystal particles which have a high alumina purity, are fine and homogeneous, have a narrow particle size distribution, and are not agglomerated particles can be obtained from raw materials of various kinds, purities, shapes, sizes, and compositions.

More specifically, the α-alumina particles produced by the process of the present invention have excellent characteristics such as an average particle diameter of from 0.1 to 30 µm, a D/H ratio of from 0.5 to 3.0, a D90/D10 ratio of not more than 10, preferably not more than 9, and more preferably not more than 7, an alumina purity of 99.90% by weight or higher, and a sodium content of less than 0.05% by weight in terms of Na₂O.

The α-alumina comprising α-alumina single crystal particles having the above-described excellent characteristics is suitable as an abrasive, a raw material for sintered products, a plasma flame spraying material, a filler, a raw material for single crystals, a raw material for a carrier of catalysts, a raw material for fluorescent substances, a raw material for encapsulations, a raw material for ceramic filters, etc. and is extremely useful in industry. Owing to the extremely high purity, the α-alumina obtained by the present invention is particularly useful as a raw material for single crystals (e.g., yttrium aluminum garnet (YAG), sapphire, ruby, etc.) and high purity sintered products to which α-alumina of low purity cannot be applied. The fine α-alumina obtained by the process of the present invention is particularly suitable as a precision abrasive or a raw material for ceramic filters.

## Claims

1. A process for producing α-alumina in a powder form comprising homogeneous and non-agglomerated α-alumina single crystal particles which have an octa- or higher polyhedral shape and a D/H ratio of from 0.5 to 3.0, wherein D represents a maximum particle diameter parallel to a hexagonal lattice plane of a hexagonal close-packed lattice of said particles, and H represents a diameter perpendicular to a hexagonal lattice plane, characterized in that transition alumina and/or a transition alumina precursor which is capable of being converted to transition alumina on heating is calcined in an atmosphere containing at least 10% by volume of hydrogen chloride at a temperature of not less than 600°C and the calcining time is 10 minutes or more up to 120 minutes.

2. A process for producing α-alumina in powder form comprising homogeneous and non-agglomerated α-alumina single crystal particles which have an octa- or higher polyhedral shape and a D/H ratio of from 0.5 to 3.0, wherein D represents a maximum particle diameter parallel to a hexagonal lattice plane of a hexagonal close-packed lattice of said particles, and H represents a diameter perpendicular to a hexagonal lattice plane, characterized in that transition alumina and/or a transition alumina precursor which is capable of being converted to transition alumina on heating is calcined, while at least 1% by volume of chlorine and at least 0.1% by volume of steam are introduced to an atmosphere, at a temperature of not less than 600°C.

3. A process for producing α-alumina as in Claim 1 or 2, wherein the calcining temperature is from 600 to 1,400°C.

4. A process for producing α-alumina as in Claim 1 or 2, wherein the calcining temperature is from 800 to 1,200°C.

5. A process for producing α-alumina as in Claim 1, 2 or 3, characterized in that said transition alumina precursor capable of being converted to transition alumina on heating is aluminum hydroxide.

6. A process for producing α-alumina as in Claim 1, 2 or 3, characterized in that said transition alumina precursor capable of being converted to transition alumina on heating is alum or aluminum sulfate.

7. A process for producing α-alumina according to Claim 2, wherein at least 10% by volume of chlorine and at least 5% by volume of steam are introduced to an atmosphere.

## Patentansprüche

1. Verfahren zur Herstellung von α-Aluminiumoxid in Pulverform, umfassend homogene und nicht-agglomerierte α-Aluminiumoxideinkristallteilchen, die eine oktaedrische oder höher polyedrische Form und ein D/H-Verhältnis von 0,5 bis 3,0 aufweisen, wobei D einen maximalen Teilchendurchmesser darstellt, der parallel zu einer hexagonalen Gitterebene einer hexagonal dichtesten Packung der Teilchen ist, und H einen Durchmesser senkrecht zu einer hexagonalen Gitterebene darstellt, dadurch gekennzeichnet, daß Übergangsaluminiumoxid und/oder eine Übergangsaluminiumoxidvorstufe, die durch Erhitzen in Übergangsaluminiumoxid überführt werden kann, in einer Atmosphäre, die mindestens 10 Vol.-% Chlorwasserstoff enthält, bei einer Temperatur von nicht weniger als 600°C gebrannt wird und die Brenndauer 10 Minuten oder mehr, bis 120 Minuten, beträgt.

2. Verfahren zur Herstellung von α-Aluminiumoxid in Pulverform, umfassend homogene und nicht-agglomerierte α-Aluminiumoxideinkristallteilchen, die eine oktaedrische oder höher polyedrische Form und ein D/H-Verhältnis von 0,5 bis 3,0 aufweisen, wobei D einen maximalen Teilchendurchmesser darstellt, der parallel zu einer hexagonalen Gitterebene einer hexagonal dichtesten Packung der Teilchen ist, und H einen Durchmesser senkrecht zu einer hexagonalen Gitterebene darstellt, dadurch gekennzeichnet, daß Übergangsaluminiumoxid und/oder eine Übergangsaluminiuimoxidvorstufe, die durch Erhitzen in die Übergangsformen des Aluminiumoxids überführt werden kann, bei einer Temperatur von nicht weniger als 600°C gebrannt wird, während mindestens 1 Vol.-% Chlorgas und mindestens 0,1 Vol.-% Dampf in eine Atmosphäre eingeführt werden.

3. Verfahren zur Herstellung von α-Aluminiumoxid nach Anspruch 1 oder 2, wobei die Brenntemperatur 600 bis 1400°C beträgt.

4. Verfahren zur Herstellung von α-Aluminiumoxid nach Anspruch 1 oder 2, wobei die Brenntemperatur 800 bis 1200°C beträgt.

5. Verfahren zur Herstellung von α-Aluminiumoxid nach Anspruch 1, 2 oder 3, dadurch gekennzeichnet, daß die Übergangsaluminiumoxidvorstufe, die durch Erhitzen in Übergangsaluminiumoxid überführt werden kann, Aluminiumhydroxid ist.

6. Verfahren zur Herstellung von α-Aluminiumoxid nach Anspruch 1, 2 oder 3, dadurch gekennzeichnet, daß die Übergangsaluminiumoxidvorstufe, die durch Erhitzen in Übergangsaluminiuimoxid überführt werden kann, Alaun oder Aluminiumsulfat ist.

7. Verfahren zur Herstellung von α-Aluminiumoxid nach Anspruch 2, wobei mindestens 10 Vol.-% Chlorgas und mindestens 5 Vol.-% Dampf in eine Atmosphäre eingeführt werden.

## Revendications

1. Procédé de préparation d'α-alumine sous forme de poudre comprenant des particules de cristal unique d'α-alumine homogènes et non agglomérées qui ont une forme octaédrique ou polyédrique supérieure et un rapport D/H de 0,5 à 3,0, dans lequel D représente un diamètre de particule maximal parallèle à un plan du réseau hexagonal d'un réseau proche serré fermement hexagonal desdites particules, et H représente un diamètre perpendiculaire au plan du réseau hexagonal, caractérisé en ce que de l'alumine de transition et /ou un précurseur d'alumine de transition qui est capable d'être converti en alumine de transition par chauffage est calciné dans une atmosphère contenant au moins 10% en volume de chlorure d'hydrogène à une température qui n'est pas inférieure à 600°C et le temps de calcination est égal à 10 minutes ou jusqu'à plus de 120 minutes.

2. Procédé de préparation d'α-alumine sous forme de poudre comprenant des particules de cristal unique d'α-alumine homogènes et non agglomérées qui ont une forme octaédrique ou polyédrique supérieure et un rapport D/H de 0,5 à 3,0, dans lequel D représente un diamètre de particule maximal parallèle à un plan du réseau hexagonal d'un réseau serré fermement hexagonal desdites particules, et H représente un diamètre perpendiculaire au plan du réseau hexagonal, caractérisé en ce que de l'alumine de transition et /ou un précurseur d'alumine de transition qui est capable d'être converti en alumine de transition par chauffage est calciné, tandis qu'au moins 1% en volume de chlore et au moins 0,1% en volume de vapeur sont introduits dans l'atmosphère, à une température qui n'est pas inférieure à 600°C.

3. Procédé de préparation d'α-alumine selon la revendication 1 ou 2, caractérisé en ce que la température de calcination est de 600 à 1400°C.

4. Procédé de préparation d'α-alumine selon la revendication 1 ou 2, caractérisé en ce que la température de calcination est de 800 à 1200°C.

5. Procédé de préparation d'α-alumine selon la revendication 1, 2 ou 3, caractérisé en ce que ledit précurseur d'alumine de transition capable d'être converti en alumine de transition par chauffage est l'hydroxyde d'aluminium.

6. Procédé de préparation d'α-alumine selon la revendication 1, 2 ou 3, caractérisé en ce que ledit précurseur d'alumine de transition capable d'être converti en alumine de transition par chauffage est l'alun ou le sulfate d'aluminium.

7. Procédé de préparation d'α-alumine selon la revendication 2, caractérisé en ce qu'au moins 10% en volume de chlore et au moins 5% en volume de vapeur sont introduits dans une atmosphère.
